# EUROPEAN PATENT APPLICATION

(11) **EP 4 765 199 A1**
(43) Date of publication of application: **24.06.2026**
(21) Application number: 24853225.1
(22) Date of filing: 11.04.2024
(51) Int. Cl.: H01L 21/67

(54) **LASER-INDUCED FIRING-BASED PROCESSING DEVICE**

(30) Priority: 14.08.2023 CN 202322179648 U
(71) Applicant: Wuhan Dr Laser Technology Corp., Ltd., Wuhan, Hubei 430078 (CN)
(72) Inventor: LI, Zhigang, Wuhan, Hubei 430078 (CN)
(74) Representative: Witte, Weller & Partner Patentanwälte mbB
(86) International application number: PCT/CN2024/087205
(87) International publication number: WO 2025/035809

(57) **Abstract**

A laser-induced firing-based processing device. The processing device comprises at least two processing stations, and a bearing apparatus (100). The at least two processing stations are each provided with a laser module (210, 310) and an electrical input module (220, 320); the bearing apparatus (100) comprises at least one bearing unit (110) and a first driving mechanism (120) for driving the bearing unit to sequentially move to a first processing station and a second processing station; the two electrical input modules (220, 320) each comprise a conductive module and a second driving mechanism (40) connected to the conductive module; the conductive module comprises a first electrode (10) and a second electrode; the first electrode (10) and the second electrode are respectively used for electrically contacting the upper surface and the lower surface of a cell; and the first electrode (10) is located above the bearing unit (110). The processing device can solve the technical problem of poor contact resistivity uniformity caused by the conductive modules shielding laser, thereby improving the photoelectric conversion efficiency and realizing mass production.

## Description

This application claims priority to the Chinese Patent Application No. 202322179648.7, titled "LASER-INDUCED FIRING-BASED PROCESSING DEVICE", filed on August 14, 2023 with the China National Intellectual Property Administration, which is incorporated herein by reference in its entirety.

### FIELD

The present application relates to the technical field of photovoltaic cells, and in particular to laser induced firing processing equipment.

### BACKGROUND

A contact resistance between a front electrode and a back electrode of a crystalline silicon solar cell has a huge impact on a fill factor and conversion efficiency. The lower the contact resistance is, the higher the fill factor and the conversion efficiency are. For major solar cell manufacturers, it is highly required for reducing the contact resistance. Moreover, in pursuit of higher conversion efficiency, a sheet resistance of an emitter in the front electrode of the crystalline silicon solar cell is increasing, making it difficult to achieve a lower contact resistance. A conventional airflow thermal cycle sintering furnace struggles to produce a good ohmic contact when sintering a paste on the cells.

In order to reduce the contact resistance, a laser induced firing technology is used, in which the carriers in the cell are excited by laser beam, flow directionally and thus form a circuit under the action of a reverse voltage from an external electric field. When the circuit current flows through the metal-semiconductor interface, a significant thermal effect is generated due to the high contact resistance between the metal and the semiconductor, and the heat in turn promotes the mutual diffusion between the metal and the semiconductor, thereby obtaining excellent contact characteristics after firing. It still requires further improvement in the photovoltaic conversion efficiency of the solar cell in the process of this technology, and the economic benefit is required to be further enhanced.

### SUMMARY

In view of this, laser induced firing processing equipment is provided in the present application, which has at least a first processing station and a second processing station. The processing equipment includes: a support module; a first laser module and a first electrical input module that are located at the first processing station; and a second laser module and a second electrical input module that are located at the second processing station. The support module includes at least one support unit and a first driving mechanism, the at least one support unit is configured for supporting a cell, and the first driving mechanism is configured to drive the at least one support unit to move sequentially from the first processing station to the second processing station.

Each of the first electrical input module and the second electrical input module includes a power source, a conductive module, and a second driving mechanism connected to the conductive module. Each conductive module includes a first electrode and a second electrode that are both electrically connected to the power source. The first electrode and the second electrode are configured to be in electrical contact with the upper surface and the lower surface of the cell respectively. The first electrode of the first electrical input module is located under the first laser module, and the first electrode of the second electrical input module is located under the second laser module. Each first electrode is positioned above the at least one support unit. The first laser module is configured to emit a laser beam to scan the cell when the conductive module of the first electrical input module is electrically connected to the upper surface and the lower surface of the cell. The second laser module is configured to emit a laser beam to scan the cell when the conductive module of the second electrical input module is electrically connected to the upper surface and the lower surface of the cell.

A position on the cell to be in contact with the first electrode of the second electrical input module at the second processing station is displaced away from a position on the same cell to be in contact with the first electrode of the first electrical input module at the first processing station.

In an embodiment, the first electrode of the first electrical input module includes at least one strip-shaped electrode element, which is referred to as a first front conductive unit, and the first electrode of the second electrical input module includes at least one strip-shaped electrode element, which is referred to as a second front conductive unit.

In an embodiment, the at least one strip-shaped electrode element of each first electrode includes any one of an elastic probe row, an elastic conductive wire, or an elastic electrode sheet.

In an embodiment, the first processing station and the second processing station are arranged in sequence in a first direction, and the first front conductive unit and the second front conductive unit both extend in a direction perpendicular to the first direction;

or, the first processing station and the second processing station are arranged perpendicularly to each other, the first front conductive unit extends in the first direction, and the second front conductive unit extends in a direction perpendicular to the first direction.

In an embodiment, the first electrode of the first electrical input module includes multiple first front conductive units arranged side by side, and the first electrode of the second electrical input module includes multiple second front conductive units arranged side by side.

If the first processing station and the second processing station are arranged in sequence in the first direction, the multiple first front conductive units and the multiple second front conductive units are arranged in sequence in the first direction;

or, if the first processing station and the second processing station are arranged perpendicularly to each other, the multiple first front conductive units are arranged in sequence in the direction perpendicular to the first direction, and the multiple second front conductive units are arranged in sequence in the first direction.

In an embodiment, each second electrode is a conductive part that is arranged on or integrally formed on the at least one support unit, and the conductive part is configured to be in contact with the lower surface of the cell. Each conductive module further includes a conductive connector, and the conductive connector is located above the at least one support unit and electrically connected to the power source. Each of the first electrical input module and the second electrical input module further includes a second driving mechanism that is connected to each first electrode and each conductive connector. The second driving mechanism is configured to move the first electrode into contact with the upper surface of the cell, and move the conductive connector into contact with the conductive part to electrically connect the second electrode to the power source.

In an embodiment, the conductive connector includes at least one conductive pillar.

In an embodiment, the conductive part is a conductive plate.

In an embodiment, the conductive plate has a greater size than that of the cell. When the at least one support unit is located at the first processing station and/or the second processing station, a projection of the first electrode on a horizontal plane faces a part of a busbar of the cell, and a projection of the conductive connector on the horizontal plane faces an area of the conductive plate in which the cell is not located.

In an embodiment, the second driving mechanism is a Z-axis driving module, and the first electrode and the conductive connector are connected to the Z-axis driving module. The Z-axis driving module is configured to lower the first electrode and the conductive connector simultaneously so that the first electrode comes into contact with the upper surface of the cell and the conductive connector comes into contact with the conductive plate.

In an embodiment, the support module is a support table, the conductive plate is arranged on an upper surface of the support table, and the cell is placed on the conductive plate.

In an embodiment, the support table is a negative-pressure-suction support table, a suction chamber is provided inside the support table, and multiple first suction channels are provided in the surface of the support table. The multiple first suction channels are in communication with the suction chamber, and the suction chamber is in communication with a vacuum generator.

In an embodiment, the conductive plate is provided with multiple second suction channels. The multiple second suction channels are in communication with the multiple first suction channels, and are configured for fixing the cell on the conductive plate by vacuum suction.

In an embodiment, the multiple first suction channels are not covered by the conductive plate.

In an embodiment, the laser induced firing processing equipment further includes a positioning station, and the positioning station is located upstream of the first processing station and the second processing station in a conveying direction of the cell in the laser induced firing processing equipment.

A position adjustment mechanism is provided at the positioning station and is configured for adjusting a position of the cell, such that when the cell, after being adjusted in position, is carried by the support unit to the first processing station and/or the second processing station, the first electrode directly faces a part of a busbar of the cell.

In an embodiment, the support module includes at least two support units for supporting the cell, the first driving mechanism is configured to move one of the support units from the first processing station to the second processing station, and move another one of the support units to the first processing station at the same time.

In an embodiment, the support unit includes a hollow portion, and the second electrode is arranged under the hollow portion. Each of the first electrical input module and the second electrical input module includes a second driving mechanism connected to the first electrode and the second electrode. The second driving mechanism is configured to move the first electrode into contact with the upper surface of the cell, and move an electrode element of the second electrode through the hollow portion into direct contact with the lower surface of the cell.

In an embodiment, each second electrode includes any one of at least one strip-shaped electrode element, at least one conductive pillar, or a conductive plate.

In an embodiment, the support module is a rotary table module, and the support unit is a support table. The first driving mechanism is a rotary driving mechanism, and the rotary table module includes a centrosymmetric bracket that is horizontally arranged.

A driving shaft of the rotary driving mechanism is vertically arranged and is connected to a center of the bracket. The support module includes at least two support units that are installed on the bracket and are equidistant from the center of the bracket.

In an embodiment, the rotary table module includes four support units. The four support units are evenly distributed in a circumferential direction of the bracket, and the first processing station is arranged adjacent to the second processing station.

The first electrode of the first electrical input module includes at least one strip-shaped electrode element, which is referred to as a first front conductive unit. The first electrode of the second electrical input module includes at least one strip-shaped electrode element, which is referred to as a second front conductive unit. The first front conductive unit extends in the first direction, and the second front conductive unit is arranged in a direction perpendicular to the first direction.

In an embodiment, the laser induced firing processing equipment further has a third station and a fourth station. The first driving mechanism is configured to drive each support unit to pass through the third station, the first processing station, the second processing station, and the fourth station in sequence.

In an embodiment, the bracket is a cross-shaped bracket. A loading conveyor is provided corresponding to the third station, and an unloading conveyor is provided corresponding to the fourth station. The third station is a loading station, and the fourth station is an unloading station. A connecting line between the loading station and the unloading station is parallel to a connecting line between the loading conveyor and the unloading conveyor.

In an embodiment, the third station is a loading station, and the fourth station is an unloading station.

A loading conveyor and a loading handling module are provided corresponding to the loading station, and an unloading conveyor and an unloading handling module are provided corresponding to the unloading station.

A positioning station is provided between the loading conveyor and the rotary table module and is provided with a position adjustment mechanism.

In an embodiment, the loading conveyor is a belt conveyor, and the loading handling module is an L-shaped rotary robotic arm assembly. The L-shaped rotary robotic arm assembly includes a first rotary driving actuator and two robotic arms that are perpendicular to each other and are connected to the first rotary driving actuator. An end of each robotic arm is connected with a suction cup that faces downward and is configured to hold the cell by suction, and the L-shaped rotary robotic arm assembly is configured to rotate by 90 degrees each time.

The loading conveyor, the loading station, the unloading station, and the unloading conveyor are collinearly arranged in sequence. The position adjustment mechanism is located on a perpendicular bisector of a connecting line between the loading station and an output end of the loading conveyor, and the position adjustment mechanism is positioned directly below one of the suction cups when the L-shaped rotary robotic arm assembly stops moving after rotating by 90 degrees.

The first rotary driving actuator is configured to move and locate the suction cups of the two robotic arms respectively above the position adjustment mechanism and the loading conveyor in one case, and above the position adjustment mechanism and the support unit corresponding to the loading station in another case.

In an embodiment, the position adjustment mechanism is a mechanical centering device, and the mechanical centering device includes a support mechanism for supporting the cell, four push plates that are arranged around the support mechanism in a square form, and a driving unit connected to the push plates. The driving unit is configured to move the push plates towards a center of the cell to position the cell.

In an embodiment, the unloading conveyor is a belt conveyor, and the unloading handling module is a straight rotary robotic arm assembly. The straight rotary robotic arm assembly includes a second rotary driving actuator and a straight robotic arm connected to the second rotary driving actuator. An end of the straight robotic arm is connected with a suction cup that faces downward and is configured to hold the cell by suction, and the straight rotary robotic arm assembly is configured to rotate by 90 degrees each time.

The second rotary driving actuator is configured to move the suction cup of the straight robotic arm in a reciprocating manner between a position above the unloading conveyor and a position above the support unit corresponding to the unloading station.

In an embodiment, both the loading conveyor and the unloading conveyor are belt conveyors, and both the loading handling module and the unloading handling module are linear robotic arm assemblies. The loading handling module includes a loading driving actuator and two suction cups connected to the loading driving actuator, and the unloading handling module includes an unloading driving actuator and a suction cup connected to the unloading driving actuator.

The loading conveyor, the positioning station, the loading station, the unloading station, and the unloading conveyor are collinearly arranged. The loading driving actuator is configured to move and locate the two suction cups of the loading handling module respectively above the loading conveyor and the position adjustment mechanism in one case, and above the position adjustment mechanism and the support unit corresponding to the loading station in another case. The unloading driving actuator is configured to move the suction cup of the unloading handling module in a reciprocating manner between a position above the unloading conveyor and a position above the support unit corresponding to the unloading station.

In an embodiment, a loading buffer module is provided on a conveying path of the loading conveyor, and/or an unloading buffer module is provided on a conveying path of the unloading conveyor.

In an embodiment, the support module is an alternating module, which further has a loading station and an unloading station, and the first processing station and the second processing station are located between the loading station and the unloading station. The support module further includes a base, on which the first processing station, the second processing station, the loading station and the unloading station are arranged. The first driving mechanism includes two horizontal displacement modules respectively arranged on both sides of the base and at least two Z-axis modules connected to the horizontal displacement modules. The alternating module includes at least two support units respectively connected to the at least two Z-axis modules, and the number of the Z-axis modules equals to the number of the support units.

In an embodiment, the support module is a conveying belt module, and the conveying belt module includes a belt, which serves as the support unit. The first driving mechanism is configured to drive the belt to rotate.

In an embodiment, the support module is any one of a rotary table module, an alternating module, or a conveying belt module.

In the present application, the following technical effects can be achieved. The laser induced firing processing equipment in the present application has two processing stations, and has two laser modules and two electrical input modules that are correspondingly arranged at the two processing stations. The first laser module and the first electrical input module as well as the second laser module and the second electrical input module are used to process the same cell in sequence. The position on the cell to be in contact with the first electrode of the second electrical input module is different from the position on the same cell to be in contact with the first electrode of the first electrical input module at the first processing station, and the areas of the cell irradiated by the two laser modules are also different. The area that is shielded by the conductive module from laser beam during the first laser irradiation is within the area irradiated during the second laser irradiation. Therefore, the issue of laser irradiation being blocked by the conductive module is addressed. In addition, a mass production can be achieved by the processing equipment.

### BRIEF DESCRIPTION OF THE DRAWINGS

FIG. 1 is a schematic structural view of laser induced firing processing equipment in an embodiment of the present application; and
FIG. 2 is a schematic structural view showing a displacement between positions on a cell to be in contact with respective first electrodes at two processing stations in the present application;
FIG. 3 is a schematic structural view of a first electrode and a conductive connector that are connected to a second driving mechanism in the present application;
FIG. 4 is a schematic structural view of the laser induced firing processing equipment in an embodiment of the present application, in which a second electrode is in direct contact with a back surface of a cell;
FIG. 5 is a schematic structural view of laser induced firing processing equipment using a rotary table module as a support module in another embodiment of the present application;
FIG. 6 is a schematic structural view of laser induced firing processing equipment using a rotary table module as a support module in another embodiment of the present application;
FIG. 7 is a schematic structural view of laser induced firing processing equipment using a rotary table module as a support module in another embodiment of the present application;
FIG. 8 is a schematic structural view of laser induced firing processing equipment using an alternating module as a support module in another embodiment of the present application;
FIG. 9 is a schematic structural view of laser induced firing processing equipment using an alternating module as a support module in another embodiment of the present application;
FIG. 10 is a schematic structural view of laser induced firing processing equipment using a belt conveyor module as a support module in another embodiment of the present application; and
FIG. 11 is a schematic structural view of a position adjustment mechanism in an embodiment of the present application.

### DETAILED DESCRIPTION OF THE EMBODIMENTS

The following is a clear and complete illustration of the embodiments of the present application in conjunction with the accompanying drawings. Obviously, the described embodiments are merely a part of the embodiments of the present application, rather than all of them. Based on the embodiments of the present application, all other embodiments obtained by those skilled in the art without paying creative labor fall within the protection scope of the present application.

In order to make the above objectives, features, and advantages of the present application more obvious and understandable, the following provides further detailed explanations of the present application in conjunction with the accompanying drawings and specific embodiments.

It is found that, when using the laser induced firing technology to reduce the contact resistance, it is necessary to bring a conductive module into contact with the cell to apply a reverse voltage. Generally, a laser module is positioned above the conductive module. When irradiating the cell by laser beam, the laser beam is partially blocked by the conductive module, leaving a part of the cell unirradiated by laser beam. Therefore, the contact characteristics at the shielded part of the cell cannot be improved, leading to low photoelectric conversion efficiency.

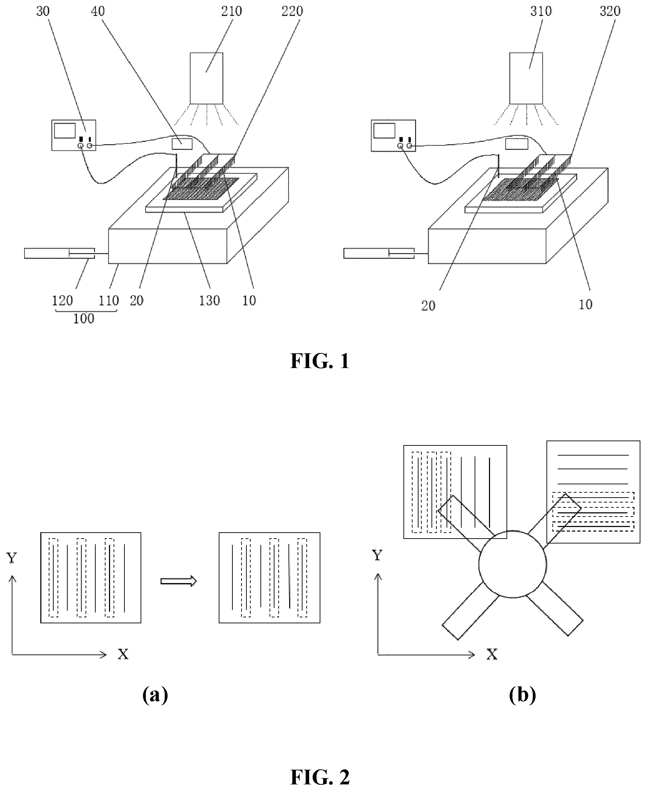

The laser beam is blocked by the conductive module, which causes a poor uniformity of the contact resistivity and a limited improvement of the photoelectric conversion efficiency of the solar cell. To address this issue, as shown in FIG. 1, laser induced firing processing equipment is provided in the present application, which has at least a first processing station and a second processing station. The processing equipment includes a support module 100, and further includes a first laser module 210 and a first electrical input module 220 that are located at the first processing station, and a second laser module 310 and a second electrical input module 320 that are located at the second processing station. The support module 100 includes at least one support unit 110 for supporting a cell and a first driving mechanism 120. The first driving mechanism 120 drives the support unit 110 to move sequentially from the first processing station to the second processing station.

Each of the first electrical input module 220 and the second electrical input module 320 includes a power source 30 and a conductive module. The conductive module of each of the two electrical input modules includes a first electrode 10 and a second electrode that are both electrically connected to the power source 30. The first electrode 10 and the second electrode are respectively configured to be in electrical contact with the upper surface and the lower surface of the cell. The first electrode 10 of the first electrical input module 220 is located under the first laser module 210, and the first electrode 10 of the second electrical input module 320 is located under the second laser module 310. Each first electrode 10 is positioned above the support unit 110. The first laser module 210 is configured to emit a laser beam to scan the cell when the conductive module of the first electrical input module 220 is electrically connected to the upper surface and the lower surface of the cell. The second laser module 310 is configured to emit a laser beam to scan the cell when the conductive module of the second electrical input module 320 is electrically connected to the upper surface and the lower surface of the cell.

Specifically, the electrical connection between the second electrode and the lower surface of the cell may be achieved in various ways. For example, the second electrode is in direct contact with the lower surface of the cell. As another example, a conductive part 130 (for example, a conductive plate) is arranged on or integrally formed on the support unit 110 as the second electrode, which is in contact with the lower surface of the cell being supported, and a conductive connector 20 is further provided to be in contact with the conductive part 130, so that the second electrode is in electrical contact with the lower surface of the cell. Any implementation method that can achieve the electrical connection between the second electrode and the lower surface of the cell falls within the protection scope of the present application. The first driving mechanism 120 may be a linear driving mechanism, such as a linear motor, and in this case, the support module 100 may be an alternating module as described below. Alternatively, the first driving mechanism 120 may be a rotary driving mechanism, such as a rotary motor, and in this case, the support module 100 may be a rotary table module as described below. Each of the two laser modules includes a laser generator and a laser scanning assembly. The laser generator is used for emitting the laser beam, and the laser scanning assembly is used for controlling a scanning direction of the laser beam. The laser scanning assembly includes, for example, a galvanometer and a field lens, or may use other scanning methods.

In an embodiment, a position on the cell to be in contact with the first electrode 10 of the second electrical input module 320 at the second processing station is displaced away from a position on the same cell to be in contact with the first electrode 10 of the first electrical input module 310 at the first processing station, which can address the issue that the laser irradiation on the cell is blocked by the conductive module. It should be noted that since the cell can be carried by the support unit to move sequentially from the first processing station to the second processing station, the cell may be kept still after arriving at the first processing station and the second processing station, as long as the positions and orientations of the first electrodes 10 at the two processing stations are preset in a staggered manner.

In addition, the first electrode 10 comes into contact with the cell at a busbar on the upper surface of the cell, and the busbar is in a strip shape. Therefore, the first electrode 10 includes at least one strip-shaped electrode element in order to be in better contact with the busbar.

Below is a further illustration of the term "displaced away from". Specifically, as shown in FIG. 2, the cell and the busbars thereof are schematically illustrated, and dashed lines are used to indicate the positions where the first electrodes 10 are in contact with the busbars at the two processing stations. FIG. 2(a) shows an example where the first processing station and the second processing station are sequentially arranged in a first direction (e.g., the X-axis direction in the figure), which corresponds to a support module in an alternating module form described below. The cells on the left and right in FIG. 2(a) are located at the first processing station and the second processing station, respectively. FIG. 2(b) shows another example where the first processing station and the second processing station are arranged perpendicularly to each other, which corresponds to a support module in a rotary table module form described below. The cells on the left and right in FIG. 2(b) are located at the first processing station and the second processing station, respectively. The term "displaced away from" refers to, for example, in FIG. 2(a) and FIG. 2(b), at the first processing station, the first electrode 10 is in contact with the busbars of the cell circled by the dashed lines in the left part of each figure, and at the second processing station, the first electrode 10 is in contact with the busbars of the cell circled by the dashed lines in the right part of each figure. FIG. 2(a) and FIG. 2(b) are only exemplary, and the number and locations of the electrode elements of the first electrodes 10 at these two processing stations are not limited. The first electrode 10 includes at least one strip-shaped electrode element, which means the number of electrode elements is not limited. There may be only one electrode element to be in contact with one busbar of the cell, or there may be multiple electrode elements that are arranged side by side to be simultaneously in contact with multiple busbars of the cell. Further, when multiple electrode elements are provided, a distance between adjacent electrode elements may be N times a distance between adjacent busbars, where N is a natural number and N ≥ 1. In addition, the electrode element of the first electrode 10 can be configured to be in contact with any busbar of the cell, which may be a busbar located in a peripheral area of the cell, or a busbar located in a central area of the cell, as long as the position of the electrode element of each first electrode 10 meets the condition described above that when the position on the cell to be in contact with the first electrode of the second electrical input module at the second processing station is displaced away from the position on the same cell to be in contact with the first electrode of the first electrical input module at the first processing station, the area shielded by the conductive module from laser beam during the first laser irradiation can fall within the area irradiated by laser beam during the second laser irradiation.

In addition, the area shielded by the first electrode 10 of the second electrical input module 320 from laser beam at the second processing station also fall within the area irradiated by laser beam at the first processing station.

During the operation, after the support unit 110 receives the cell, a part of a to-be-irradiated area of the cell is firstly processed through the first laser module 210 and the first electrical input module 220 at the first processing station. After that, the first driving mechanism 120 is activated to drive the support unit 110 to transfer the cell from the first processing station to the second processing station, and then the remaining part of the to-be-irradiated area of the cell is processed through the second laser module 310 and the second electrical input module 320. The cell is processed at the two processing stations in similar ways. Specifically, the conductive module is driven by a second driving mechanism 40 to be electrically connected to the cell. The conductive module applies a voltage, while the laser module uses laser beam to scan a partial area of the cell. After the processing is completed at this station, the laser beam is turned off, and the conductive module is driven by the second driving mechanism 40 so that the conductive module is no longer in contact with the cell.

The laser induced firing processing equipment in the present application has two processing stations, and has two laser modules and two electrical input modules that are correspondingly arranged at the two processing stations. The first laser module and the first electrical input module as well as the second laser module and the second electrical input module are used to process the same cell in sequence, with the relative position between the cell and each conductive module, especially the first electrode 10, being changed. The first electrical input module 220 and the second electrical input module 320 come into contact with the cell at different positions on the cell, and thus the areas of the cell irradiated by the two laser modules are also different. The area shielded by the conductive module during the first laser irradiation is within the area irradiated during the second laser irradiation. Therefore, it is possible to address the issue that the laser irradiation of the cell is blocked by the conductive module. In addition, a mass production can be achieved by the processing equipment.

In another embodiment, the first electrode 10 of the first electrical input module 220 includes at least one strip-shaped electrode element, which is referred to as a first front conductive unit, and the first electrode 10 of the second electrical input module 320 includes at least one strip-shaped electrode element, which is referred to as a second front conductive unit. Herein, it should be noted that, the strip-shaped electrode element refers to an electrode element whose overall contour, as projected onto a horizontal plane, is strip-shaped (along a straight line). Since the busbar of the cell to be in contact with the first electrode 10 is strip-shaped, the electrode element is configured to be strip-shaped to facilitate the contact between the first electrode 10 and the busbar. The electrode element of the first electrode 10 includes an elastic probe row structure (i.e., a row of elastic probes that are collinearly arranged and connected to a lower portion of a probe holder, and are configured to be in contact with the cell), or an elastic conductive wire, or an elastic electrode sheet in a strip shape (which may be in surface contact with the cell). The structure of the electrode element of the first electrode 10 is not limited to these examples.

Further, the first processing station and the second processing station are arranged in sequence in a first direction. That is, the cell moves rectilinearly when it is driven by the support unit 110 to pass through the first processing station and the second processing station in sequence. The first direction is, for example, the X-axis direction in FIG. 2(a), which corresponds to a support module in an alternating module form described below. In this case, the first front conductive unit and the second front conductive unit both extend in a direction perpendicular to the first direction, such as the Y-axis direction shown in FIG. 2(a). When the cell on the support unit 110 is driven by the first driving mechanism 120 to move to a position under the second electrical input module, the position on the cell to be in contact with the second electrical input module at the second processing station is offset in the first direction (i.e., in the X-axis direction) from the position on the same cell to be in contact with the first electrical input module at the first processing station. An offset distance may be N times a distance between adjacent busbars, where N is a natural number and N ≥ 1, so that the first electrode 10 can be in contact with the busbar of the cell at the second processing station.

Alternatively, the first processing station and the second processing station are arranged perpendicularly to each other. Specifically, the support unit 110 is rotated by the first driving mechanism 120 by 90 degrees when moving from the first processing station to the second processing station. That is, when the same cell carried by the support unit 110 is transferred from the first processing station to the second processing station, the cell has been rotated by 90 degrees by the support unit 110 on the horizontal plane, as shown in FIG. 2(b). This case corresponds to a support module 100 in a rotary table module form described below. The first front conductive unit extends in a first direction, such as the Y-axis direction in the figure, and the second front conductive unit extends in a direction perpendicular to the first direction, i.e., the X-axis direction. As such, when the support unit 110 rotates the cell by 90 degrees, the first electrode 10 can be in contact with the busbar of the cell at the second processing station.

In a further solution of the above embodiment, the first electrode 10 of the first electrical input module 220 includes multiple first front conductive units arranged side by side, and the first electrode 10 of the second electrical input module 320 includes multiple second front conductive units arranged side by side. That is, each of the first electrical input module 220 and the second electrical input module 320 includes more than one front conductive unit, such as two, or even more. In case of two front conductive units, the two front conductive units may be in contact with the busbars on two sides of the upper surface of the cell, respectively, or may be in contact with the busbars close to the middle of the upper surface of the cell. The contact position is not limited, as long as when the support unit 110 moves the cell to the second processing station for laser irradiation, the area of the cell shielded by the first electrode 10 of the first electrical input module 220 from laser beam is not shielded by the first electrode 10 of the second electrical input module 320. That is, the area shielded by the conductive module during the first laser irradiation is within the area irradiated during the second laser irradiation.

If the first processing station and the second processing station are arranged in sequence in the first direction, as shown in the FIG. 2(a), the multiple first front conductive units and the multiple second front conductive units are arranged in sequence in the first direction (the X-axis direction).

Alternatively, if the first processing station and the second processing station are arranged perpendicularly to each other, as shown in FIG. 2(b), the multiple first front conductive units are arranged in sequence in the direction (the X-axis direction) perpendicular to the first direction, and the multiple second front conductive units are arranged in sequence in the first direction (the Y-axis direction).

In another embodiment, the second electrode is a conductive part 130 arranged on or integrally formed on the support unit 110, which is configured to be in contact with the lower surface of the cell. The conductive module further includes a conductive connector 20, which is located above the support unit 110 and electrically connected to the power source 30. Each of the first electrical input module 220 and the second electrical input module 320 further includes a second driving mechanism 40 connected to the first electrode 10 and the conductive connector 20. That is, the first electrical input module 220 includes a second driving mechanism 40, and the second electrical input module 320 also includes a second driving mechanism 40. The first electrode 10 is driven by the second driving mechanism 40 to come into contact with the upper surface of the cell, and the conductive connector 20 is driven by the second driving mechanism 40 to come into contact with the conductive part 130, so that the second electrode (i.e. the conductive part 130) is electrically connected to the power source 30. The conductive part 130 may be arranged on or integrally formed on the support unit 110 in various forms. For example, at least a part of a surface of the support unit 110 serves as the conductive part 130. Specifically, the entire support unit 110 may be made of conductive material, and the cell is directly placed on the conductive support unit 110. Alternatively, only a part of the surface of the support unit 110 is made of conductive material, and preferably, an outer surface of the support unit 110 is conductive, and a lower surface of the cell is in contact with this surface of the support unit 110. As another example, the support unit 110 may be a support table as described below. A conductive plate 130 is arranged on the surface of the support table and serves as the conductive part 130, and the cell is placed on the conductive plate. For all possible forms, the cell is in contact with the conductive part 130, and the conductive connector 20 is driven by the second driving mechanism 40 to come into contact with the conductive part 130. The second driving mechanism 40 may be a single driving actuator, that is, the first electrode 10 and the conductive connector 20 share the same driving actuator; or, the first driving mechanism 120 may be two driving actuators, that is, the first electrode 10 and the conductive connector 20 are driven by different driving actuators.

In another embodiment, the conductive connector 20 includes at least one conductive pillar. That is, in order to achieve the electrical connection, the conductive connector 20 only needs to have at least one contact point to be connected to the conductive part. Preferably, four conductive pillars are provided, which are separately arranged on both lateral sides of the cell.

In another embodiment, the conductive part 130 is a conductive plate, which is arranged on an upper surface of the support unit 110. The cell is supported by the conductive plate so that the conductive part 130 is in contact with the lower surface of the cell. The support unit 110 is connected to the first driving mechanism 120, and the conductive connector 20 is driven by the second driving mechanism 40 to come into contact with the conductive plate, thereby achieving the electrical connection. The conductive part 130 has a plate shape, which facilitates the contact between the conductive plate and the sheet-like cell.

In another embodiment, the conductive plate has a greater size than that of the cell. When the support unit 110 is located at the first processing station and/or the second processing station, a projection of the first electrode 10 on the horizontal plane faces a part of the busbar of the cell, and a projection of the conductive connector 20 on the horizontal plane faces an area of the conductive plate in which the cell is not located. Alternatively, the size of the conductive plate may be less than the size of the cell. Comparatively, in the case that the size of the conductive plate is greater than that of the cell, it is more beneficial for the conductive connector 20 to be in direct contact with the conductive plate, and thus this implementing method is simpler. More specifically, in this embodiment, it is preferred that the conductive connector 20 is driven by the second driving mechanism 40 to be in contact with the conductive part 130, that is, in contact with the upper surface or a lateral surface of the conductive plate.

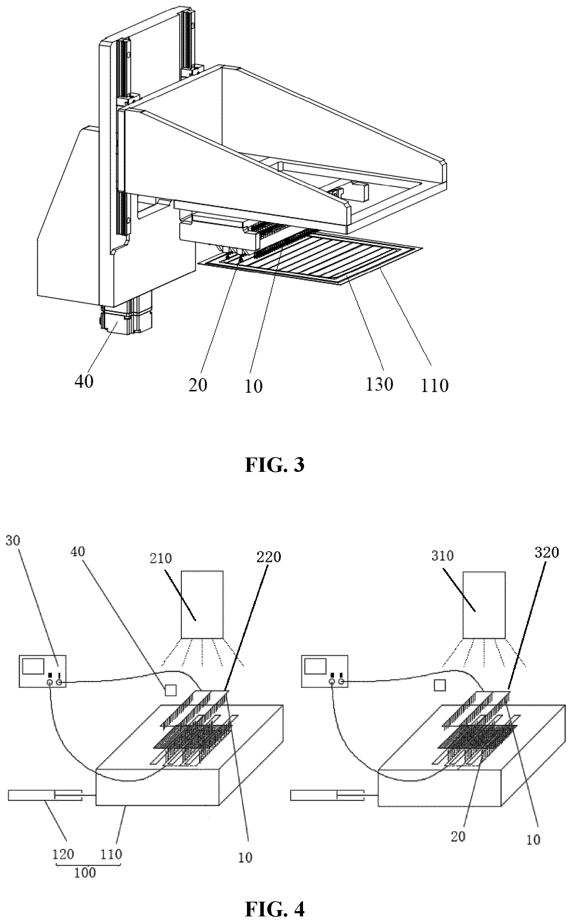

In another embodiment, as shown in FIG. 3, the second driving mechanism 40 is a single driving actuator, that is, the first electrode 10 and the conductive connector 20 share the same driving actuator. Specifically, the second driving mechanism is a Z-axis driving module, and the first electrode 10 and the conductive connector 20 are both connected to the Z-axis driving module. The first electrode 10 and the conductive connector 20 are driven by the Z-axis driving module to be simultaneously lowered so that the first electrode 10 is in contact with the upper surface of the cell and the conductive connector 20 is in contact with the conductive plate. The Z-axis driving module may be a linear motor or a pneumatic cylinder.

In this case, since the cell is placed on the surface of the conductive plate, a height of the cell relative to the supporting unit 110 is greater than a height of the conductive plate relative to the supporting unit 110. The first electrode 10 and the conductive connector 20 are in contact with the cell and the conductive plate, respectively. Therefore, it is preferred that a distance between a bottom of the first electrode 10 and the upper surface of the supporting unit 110 is greater than a distance between a bottom of the conductive connector 20 and the upper surface of the supporting unit 110. In this way, when the first electrode 10 and the conductive connector 20 are simultaneously moved downward, the first electrode 10 will not crush the cell. Alternatively, two driving actuators may be provided to lower the first electrode 10 and the conductive connector 20, respectively. Alternatively, the conductive connector 20 may be movably connected so as to avoid crushing the cell.

More specifically, as shown in FIG. 3, the Z-axis driving module is connected to a support bracket, and both the first electrode 10 and the conductive connector 20 are connected to the support bracket, so that the first electrode 10 and the conductive connector 20 are supported and positioned above the support unit 110. As further shown in the figure, the conductive connector 20 is located outside relative to the first electrode 10, so that the projection of the first electrode 10 on the horizontal plane faces a part of the busbar of the cell, and the projection of the conductive connector 20 on the horizontal plane faces the area of the conductive plate in which the cell is not located.

Further, the conductive plate 130 is preferably made of copper, which has a good conductivity and is inexpensive.

Further, each of the support unit 110 and the conductive plate 130 has a hollow portion, and hollow portions of the support unit 110 and the conductive plate 130 are aligned with each other in the height direction. The hollow portion helps to prevent the cell from being fragmented by debris.

In another embodiment, the support unit 110 is a support table. A conductive plate is arranged on the upper surface of the support table, and the cell is placed on the conductive plate. Of course, the support unit 110 may be in other forms, such as a belt.

In another embodiment, the support table is a negative-pressure-suction support table. A suction chamber is provided inside the support table, and multiple first suction channels are provided in the surface of the support table. The first suction channels are in communication with the suction chamber, and the suction chamber is in communication with a vacuum generator.

Further, the conductive plate is provided with multiple second suction channels, which are in communication with the first suction channels. The second suction channels are used to fix the cell on the conductive plate 130 by vacuum suction to prevent the position of the cell from shifting during the movement of the support unit 110.

Alternatively, the first suction channels are not covered by the conductive plate. Specifically, the conductive plate has a hollow portion, and at least a part of the first suction channels face the hollow portion. Preferably, the first suction channels run through the hollow portion and are located at the same level as that of the surface of the conductive plate. The first suction channels are used to fix the cell on the conductive plate 130 by suction to prevent the position of the cell from shifting during the movement of the support unit 110.

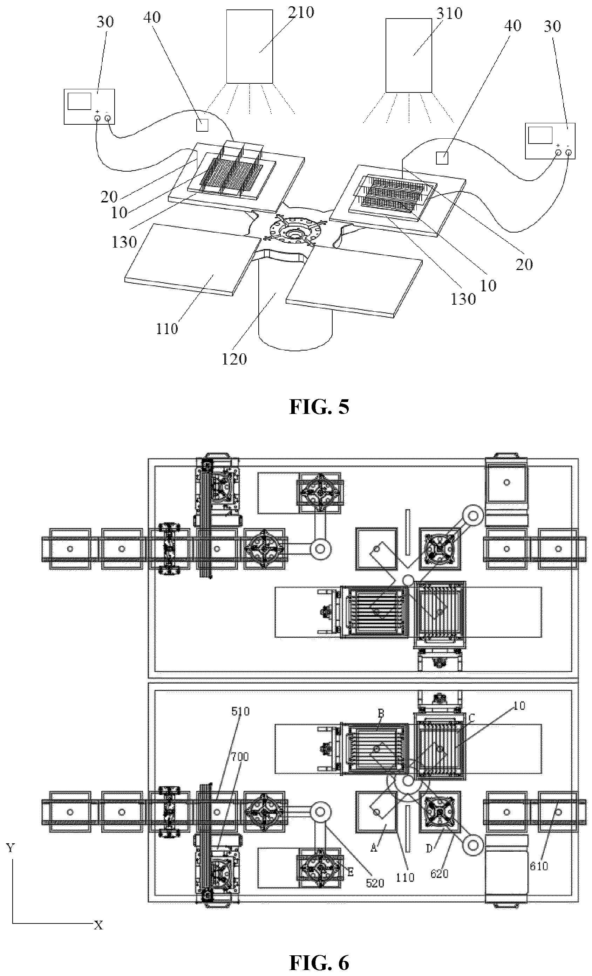

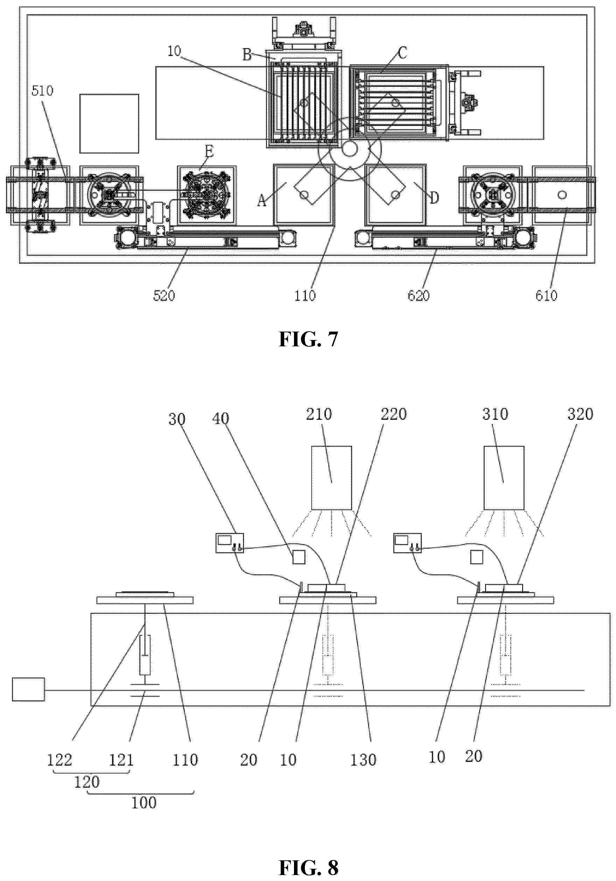

In another embodiment, the laser induced firing processing equipment further includes a positioning station, which is located upstream of the first processing station and the second processing station in a conveying direction of the cell in the processing equipment. For example, the positioning station is indicated by the label E in FIG. 6 and FIG. 7. Herein, the conveying direction of the cell in the processing equipment refers to the direction in which the cell is moved from a loading station to the first processing station, then the second processing station, and then an unloading station. The positioning station is located upstream of the first processing station and the second processing station, which means that the positioning station may be located on a moving path of the cell before it is transferred to the support module 100, according to an example as shown in FIG. 6 and FIG. 7. In another example, the positioning station may alternatively be provided on the support module 100, that is, the cell is photographed and positioned on the support module 100 after being transferred to the support module 100.

A position adjustment mechanism is provided at the positioning station and is used to adjust the position of the cell. When the cell, after being adjusted in position, is carried by the support unit 100 to move to the first processing station and/or the second processing station, the first electrode 10 directly faces a part of the busbar of the cell. The position adjustment mechanism ensures the first electrode 10 at each of the two processing stations to come into contact with the busbar of the cell correctly.

In another embodiment, the support module 100 includes at least two support units 110 for supporting cells. The first driving mechanism 120 is configured to drive one of the support units 100 to move from the first processing station to the second processing station, and drive another one of the support units 110 to move to the first processing station (e.g. from the loading station) at the same time. Due to the fact that the support module 100 has at least two support units 110, the two processing stations can work at the same time, thereby improving the processing efficiency. Specifically, when a partial area of a current cell is being processed at the first processing station, the remaining area (the area that was not processed at the first processing station, including the area shielded by the conductive module from laser beam) of a previous cell is being processed at the second processing station at the same time.

In another embodiment, as shown in FIG. 4, the support unit 110 includes a hollow portion, and the second electrode is arranged under the hollow portion. Each of the first electrical input module 220 and the second electrical input module 320 includes a second driving mechanism 40 connected to the first electrode 10 and the second electrode. The first electrode 10 is driven by the second driving mechanism 40 to come into contact with the upper surface of the cell, and an electrode element of the second electrode is driven by the second driving mechanism 40 to pass through the hollow portion to be in direct contact with the lower surface of the cell, thereby achieving the electrical connection between the second electrode and the lower surface of the cell. Specifically, the electrode element of the second electrode may have a structure as indicated by the reference number 20 in FIG. 4, which includes at least one strip-shaped electrode element. Alternatively, the second electrode may include at least one conductive pillar, or the second electrode may be a conductive plate. Further, the support unit 110 may be provided with a suction channel in communication with the vacuum generator so as to fix the cell by suction. In addition, the second driving mechanism 40 may be a single driving actuator, that is, the first electrode 10 and the second electrode share the same driving actuator. Alternatively, the first driving mechanism 120 may be two driving actuators, which drive the first electrode 10 and the second electrode to come into contact with the upper and lower surfaces of the cell, respectively.

Further, the support module 100 may be any one of a rotary table module, an alternating module, or a conveying belt module.

Specifically, as shown in FIG. 5, the support module 100 is a rotary table module, the support unit 110 is a support table, and the first driving mechanism 110 is a rotary driving mechanism. The rotary table module includes a centrosymmetric bracket that is horizontally arranged. A driving shaft of the rotary driving mechanism is vertically arranged and connected to the center of the bracket. The support module 100 includes at least two support units 110, which are installed on the bracket and are equidistant from the center of the bracket. The support module 100 is in the form of a rotary table module, which is beneficial for improving the production capacity for mass production.

Further, the support module 100 includes at least three support units 110. In this case, the processing equipment further includes at least a third station, which can be used for loading, or for both loading and unloading. The rotary driving mechanism is configured to drive the at least three support units 110 to sequentially pass through the third station, the first processing station, and the second processing station, which are arranged in a closed loop.

In another embodiment, as shown in FIG. 6 and FIG. 7, four support units 110 are provided, and these four support units 110 are evenly distributed in a circumferential direction of the bracket. In this case, the bracket may be a cross-shaped bracket. The first processing station is arranged adjacent to the second processing station. The first electrode 10 of the first electrical input module 220 includes at least one strip-shaped electrode element, referred to as a first front conductive unit. The first electrode 10 of the second electrical input module 320 includes at least one strip-shaped electrode element, referred to as a second front conductive unit. The first front conductive unit extends in a first direction (for example, the X-axis direction in FIG. 6), and the second front conductive unit is arranged in a direction perpendicular to the first direction (for example, the Y-axis direction in FIG. 6). The two processing stations are arranged adjacent to each other, so that after a partial area of the cell is irradiated, the remaining area can be irradiated at the next station. The support unit 110 is rotated by 90 degrees to be moved from the first processing station to the second processing station, and thus the cell is also rotated by 90 degrees. Therefore, the second front conductive unit is arranged in the direction perpendicular to the first direction. In addition, a position of the first electrode 10 at the first processing station and a position of the first electrode 10 at the second processing station are pre-arranged in such a way that they will contact the same cell at different positions on the cell, thereby addressing the issue of laser irradiation being blocked by the conductive module, referring to the example shown in FIG. 2(b).

In another embodiment, the processing equipment further has a third station and a fourth station. The support unit 110 is driven by the first driving mechanism 120 to pass through the third station, the first processing station, the second processing station, and the fourth station in sequence. When the rotary driving mechanism rotates by 90 degrees, the support unit 110 is rotated and moved to the next station. The rotary driving mechanism rotates by 90 degrees each time, and thus adjacent support tables are oriented perpendicular to each other in the horizontal plane.

In another embodiment, as shown in FIG. 6 and FIG. 7, the bracket is a cross-shaped bracket. A loading conveyor is provided corresponding to the third station, and an unloading conveyor is provided corresponding to the fourth station. A connecting line between the loading station and the unloading station is parallel to a connecting line between the loading conveyor and the unloading conveyor. In this case, a projection of the bracket on the horizontal plane is X-shaped. Therefore, when arranging the two laser modules at the two laser processing stations, the two laser modules may also be collinearly placed, which can save space in a direction perpendicular to the connecting line between the loading conveyor and the unloading conveyor (referring to the space in the Y direction in FIG. 6). Further, when two pieces of processing equipment are provided and arranged in the direction perpendicular to the connecting line between the loading conveyor and the unloading conveyor (referring to the space in the Y direction in FIG. 6), more space are saved.

Further, as shown in FIG. 6 and FIG. 7, the third station is a loading station A, and the fourth station is an unloading station D. That is, these four stations are the loading station A, the first processing station B, the first processing station C, and the unloading station D in sequence. The rotary driving mechanism is configured to drive the support unit 110 to pass through the loading station A, the first processing station B, the first processing station C, and the unloading station D in sequence. A loading conveyor 510 and a loading handling module 520 are provided corresponding to the loading station A, and an unloading conveyor 610 and an unloading handling module 620 are provided corresponding to the unloading station D. A positioning station E is located between the loading conveyor 510 and the support module 100 and is equipped with a position adjustment mechanism.

Specifically, in an embodiment, as shown in FIG. 6, the loading conveyor 510 is a belt conveyor. The loading handling module 520 is an L-shaped rotary robotic arm assembly, including a first rotary driving actuator and two robotic arms that are perpendicular to each other and are connected to the first rotary driving actuator. An end of each robotic arm is connected with a suction cup that faces downward and is configured to hold the cell by suction. The first rotary driving actuator is configured to rotate the two robotic arms synchronously, and the L-shaped rotary robotic arm assembly can rotate by 90 degrees each time. The loading conveyor 510, the loading station A, the unloading station D, and the unloading conveyor 610 are collinearly arranged in sequence, and are arranged in the X-axis direction in sequence as specifically shown in FIG. 6. The position adjustment mechanism is located on a perpendicular bisector of a connecting line between the loading station A and an output end of the loading conveyor 510. In other words, the position adjustment mechanism is positioned directly below one of the suction cups when the L-shaped rotary robotic arm assembly stops moving after rotating by 90 degrees. That is, the first rotary driving actuator is configured to move and locate the suction cups of two rotary robotic arms respectively above the position adjustment mechanism and the loading conveyor 510 in one case, and above the position adjustment mechanism and the support unit 110 corresponding to the loading station A in another case. The loading handling module 520 is an L-shaped rotary robotic arm assembly, and the position adjustment mechanism is positioned on a rotary path of the rotary robotic arm assembly, which can greatly improve the production capacity.

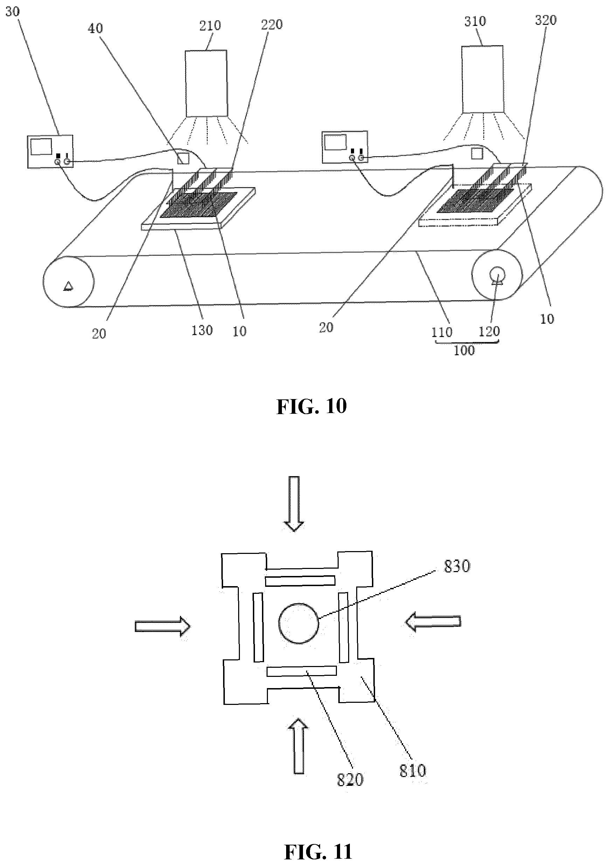

Further, the position adjustment mechanism is a mechanical centering device, as shown in FIG. 11. The mechanical centering device includes a support mechanism 810 for supporting the cell, four push plates 820 that are arranged around the support mechanism 810 in a square form, and a driving unit 830 connected to the push plates 820. The four push plates 820 are driven by the driving unit 830 to move towards the center of the cell, so that the cell is clamped among the four push plates 820 to be positioned. Furthermore, the position adjustment mechanism is designed as a mechanical centering device, which can further improve the production capacity due to a relatively shorter centering time.

During the operation, the loading conveyor 510 transfers the cell to a position under the suction cup of the L-shaped rotary robotic arm assembly. The suction cup of the L-shaped rotary robotic arm assembly picks up the cell, and the L-shaped rotary robotic arm assembly rotates by 90 degrees to move the cell to the positioning station E. After the cell is adjusted in position by the position adjustment mechanism, the L-shaped rotary robotic arm assembly rotates by another 90 degrees, so that the positioned cell is transferred to the loading station A and placed on the corresponding support unit 110. It should be noted that the two suction cups of the L-shaped rotary robotic arm assembly can work simultaneously, that is, one suction cup picks up the cell from the loading conveyor 510, and the other suction cup picks up the cell that has been adjusted in position. After the L-shaped rotary robotic arm assembly rotates by 90 degrees, one suction cup places the cell obtained from the loading conveyor 510 on the position adjustment mechanism for positioning, and the other suction cup places the position-adjusted cell on the support unit 110.

Further, the unloading conveyor 610 is a belt conveyor, as shown in FIG. 6. In the above embodiment, in order to make the direction of the cell transferred from the support module 100 to the unloading conveyor 610 be the same as the direction of the cell transferred by the loading conveyor 510, the unloading handling module 620 is a straight rotary robotic arm assembly, which includes a second rotary driving actuator and a straight robotic arm connected to the second rotary driving actuator. An end of the robotic arm is connected with a suction cup that faces downward and is configured to hold the cell by suction, and the robotic arm can rotate by 90 degrees each time. The second rotary driving actuator is configured to carry the suction cup of the straight robotic arm assembly to rotate by 90 degrees in a reciprocating manner between a position above the unloading conveyor 610 and a position above the support unit 110 corresponding to the unloading station D. The straight rotary robotic arm assembly, which is in a rotary driving mode, can move the cell faster, thereby further improving the production capacity while ensuring the orientation of the cell to be the same during loading and unloading.

In another embodiment, as shown in FIG. 7, both the loading conveyor 510 and the unloading conveyor 610 are belt conveyors, and both the loading handling module 520 and the unloading handling module 620 are linear robotic arm assemblies. The loading handling module 520 includes a loading driving actuator and two suction cups connected to the loading driving actuator. The unloading handling module 620 includes an unloading driving actuator and a suction cup connected to the unloading driving actuator. The loading driving actuator and the unloading driving actuator may be linear motors, which drive the respective suction cups to move linearly. Herein, the loading conveyor 510, the positioning station E, the loading station A, the unloading station D, and the unloading conveyor 610 are collinearly arranged in sequence. The loading driving actuator is configured to move and locate the two suction cups of the loading handling module respectively above the loading conveyor 510 and the position adjustment mechanism in one case, and above the position adjustment mechanism and the support unit 110 corresponding to the loading station A in another case. The unloading driving actuator is configured to move the suction cup of the unloading handling module in a reciprocating manner between a position above the unloading conveyor 610 and a position above the support unit 10 corresponding to the unloading station D to facilitate loading, positioning, and unloading of the cell. Herein, the position adjustment mechanism may have various forms, such as a combination of a camera and an XYθ motion platform, or a mechanical centering module described above. During the operation, the linear robotic arm assembly picks up the cell conveyed by the loading conveyor 510, and then laterally moves the cell to the positioning station E for positioning. After positioning, the linear robotic arm assembly transfers the cell from the positioning station E to the loading station A, and places the cell on the support unit 110 corresponding to the loading station A. It should be noted that the two suction cups of the linear robotic arm assembly can work simultaneously, that is, one suction cup picks up the cell on the loading conveyor 510, and the other suction cup picks up the cell that has been adjusted in position. After that, the linear robotic arm assembly moves laterally by a distance, so that the one suction cup places the cell picked up at the loading conveyor 510 onto the position adjustment mechanism for positioning, and the other suction cup places the cell that has been adjusted in position onto the support unit 110.

In another embodiment, as shown in FIG. 6, a loading buffer module 700 is provided on a conveying path of the loading conveyor 510, and/or an unloading buffer module (not shown in the figures, similar to the structure of the loading buffer module 700) is provided on a conveying path of the unloading conveyor 610. Herein, the loading buffer module 700 has a conventional structure in the related art. For example, it includes a material box provided on a lateral side of the loading conveyor 510 and a loading buffer handling module provided above the loading conveyor 510 and the loading buffer module 700. By providing the loading buffer module 700, when it is required to temporarily store the cell transferred by the loading conveyor 510, the cell on the loading conveyor 510 can be transferred into the material box by the loading buffer handling module. The unloading buffer module has a similar working principle to that of the loading buffer module 700.

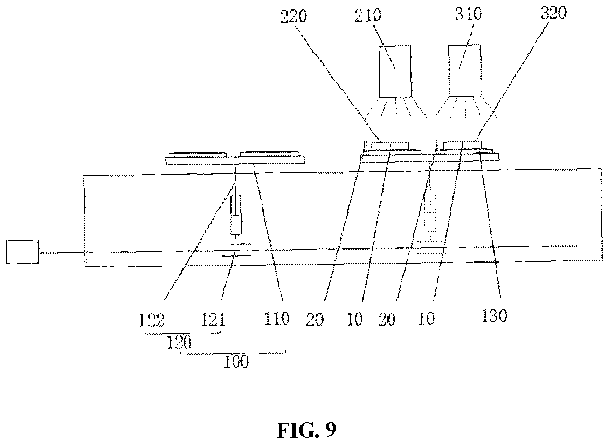

In another embodiment, as shown in FIG. 8 and FIG. 9, the support module 100 is an alternating module, which further has a loading station and an unloading station. The first processing station and the second processing station are located between the loading station and the unloading station. The support module 100 further includes a base, and the four processing stations are provided on the base. The first driving mechanism includes two horizontal displacement modules 121 arranged on both sides of the base. The first driving mechanism 120 further includes at least two Z-axis modules 122 connected to the horizontal displacement modules 121. The alternating module includes at least two support units 110, which are connected to the at least two Z-axis modules 122, respectively. The number of the Z-axis modules 122 equals to the number of the support units 110. Specifically, each support unit 110 of the alternating module is a support table, which may be a negative-pressure-suction support table to prevent the position of the cell from shifting during the movement. In this embodiment, the loading station, the first processing station, the second processing station, and the unloading station are arranged in sequence in the first direction, and multiple first front conductive units and multiple second front conductive units are arranged in sequence in the first direction. In order to prevent the first electrode 10 from affecting the laser irradiation effects, a position on the cell to be in contact with the first electrode 10 of the second electrical input module 320 at the second processing station is offset relative to a position on the same cell to be in contact with the first electrode 10 of the first electrical input module 220 at the first processing station. The mass production can also be achieved through the form of linkage platform module.

The linkage platform may have various structural forms for operation. In one of these structural forms, as shown in FIG. 8, the support module 100 includes at least three support units 110, which are respectively connected to at least three Z-axis modules 122. The number of the Z-axis modules 122 equals to the number of the support units 110. Herein, each support unit 110 is configured to support at least one cell. One Z-axis module 122 and one support unit 110 together form a conveying assembly, that is, the support module 100 includes at least three conveying assemblies. The at least three conveying assemblies are configured to drive a first support unit 110 of the at least three support units 110 to move from the first processing station to the second processing station, drive a second support unit 110 of the at least three support units 110 to move from the processing station to the first processing station, and drive a third support unit 110 of the at least three support units 110 to move leftward or rightward in a horizontal direction and/or move upward or downward in a vertical direction so as to sequentially pass through the unloading station, the loading station, the first processing station, and the second processing station, and this cycle is repeated. Through the above alternating module, the processing efficiency of the processing equipment can be greatly improved while mass production can be achieved.

In one of these structure forms, specifically, as shown in FIG. 9, the support module 100 includes at least two support units 110, which are respectively connected to at least two Z-axis modules 122. The number of the Z-axis modules 122 equals to the number of the support units 110, and each support unit 110 is configured to support at least two cells. One Z-axis module 122 and one support unit 110 together form a conveying assembly. That is, the support module 100 includes at least two conveying assemblies. The at least two conveying assemblies are configured to drive a first support unit 110 and a second support unit 110 of the at least two support units 110, such that the first support unit 110 moves a first cell from the first processing station to the second processing station, and then moves a second cell from the first processing station to the second processing station, and the second support unit 110 moves two cells leftward or rightward in the horizontal direction and/or moves two cells upward or downward in the vertical direction, making the two cells sequentially pass through the unloading station, the loading station, the first processing station, and the second processing station, and this cycle is repeated.

In another embodiment, as shown in FIG. 10, the support unit 110 is a conveying belt module, which includes a belt. The belt serves as the support unit, which is driven by the first driving mechanism 110 to rotate, so that the belt carries and moves the cell sequentially through the first processing station and the second processing station. Specifically, in this embodiment, the belt may be a conductive belt, or a conductive plate is placed on the belt. The conductive plate serves as the conductive part 130, and the cell is placed on the conductive plate. The first driving mechanism 110 drives the belt to rotate, so that the belt carries and moves the conductive plate and the cell on the conductive plate through the first processing station and the second processing station in sequence. Herein, the first driving mechanism 120 is a driving structure of a conventional belt conveyor assembly. More specifically, suction channels may be provided in a surface of the belt to prevent the position of the cell from shifting during the movement. Further, the belt conveyor may include two narrow belts that are spaced apart, so as to form a hollow portion of the support unit.

### First Embodiment

As shown in FIG. 6, laser induced firing processing equipment has a loading station A, a first processing station B, a first processing station C, and an unloading station D arranged in sequence. The laser induced firing processing equipment includes a support module 100, and further includes a first laser module 210 and a first electrical input module 220 that are located at the first processing station, and a second laser module 310 and a second electrical input module 320 that are located at the second processing station. The support module 100 includes four support units 110 and a first driving mechanism 120. The support units 110 are used for supporting a cell, and the first driving mechanism 120 drives each of the four support units 110 to pass through the loading station A, the first processing station B, the first processing station C, and the unloading station D in sequence. The first driving mechanism 120 is a rotary driving mechanism. Each of the first electrical input module 220 and the second electrical input module 320 includes a conductive module and a second driving mechanism 40. The conductive module includes a first electrode 10, a second electrode, and a conductive connector 20. Each support unit 110 is a support table, and the second electrode is a conductive plate arranged on a surface of the support table. The conductive plate supports the cell, and the conductive connector 20 is driven by the second driving mechanism 40 to come into contact with the conductive plate, thereby achieving an electrical connection. In this embodiment, the first processing station is arranged perpendicular to the second processing station, and an extension direction of a front conductive unit of the first electrode 10 of the first electrical input module 220 is perpendicular to an extension direction of a front conductive unit of the first electrode 10 of the second electrical input module 320.

A loading conveyor 510 and a loading handling module 520 are provided corresponding to the loading station A, and an unloading conveyor 610 and an unloading handling module 620 are provided corresponding to the unloading station D. A positioning station E is provided between the loading conveyor 510 and the support module 100, and the positioning station E is equipped with a position adjustment mechanism. The loading handling module 520 is an L-shaped rotary robotic arm assembly, and the positioning station E is located on a rotary path of the rotary robotic arm assembly. The unloading handling module 620 is a straight rotary robotic arm assembly.

### Second Embodiment

As shown in FIG. 7, the difference of this embodiment from the above embodiment lies in the structures of the loading handling module 520 and the unloading handling module 620. In this embodiment, a linear robotic arm assembly is adopted, and its specific working manner has been described above. In addition, the positioning station E in this embodiment is collinear with the loading station and the unloading station.

The various embodiments in the specification are described in a progressive or parallel manner, or a combination thereof. Each embodiment is specially described in respect of its differences from other embodiments, and the same and similar parts between the embodiments can be referred to each other. The description of the apparatus disclosed in the embodiments is simple, as it corresponds to the method disclosed in the embodiments. For the relevant description, please refer to the method section.

The above description of the disclosed embodiments enables those skilled in the art to implement or use the present application. Various modifications to those embodiments are apparent to those skilled in the art. The general principles defined in the context can be implemented in other embodiments without departing from the spirit or scope of the present application. Therefore, the present application is not limited to those described embodiments, but conforms to the widest scope consistent with the principles and novel features disclosed in the context.

## Claims

1. Laser induced firing processing equipment, comprising:
at least a first processing station and a second processing station;
a support module;
a first laser module and a first electrical input module, which are located at the first processing station; and
a second laser module and a second electrical input module, which are located at the second processing station, wherein
the support module comprises at least one support unit and a first driving mechanism, the at least one support unit is configured for supporting a cell, and the first driving mechanism is configured to drive the at least one support unit to move sequentially from the first processing station to the second processing station;
each of the first electrical input module and the second electrical input module comprises a power source and a conductive module, the conductive module comprises a first electrode and a second electrode that are both electrically connected to the power source, the first electrode and the second electrode are configured to be in electrical contact with the upper surface and the lower surface of the cell respectively, the first electrode of the first electrical input module is located under the first laser module, and the first electrode of the second electrical input module is located under the second laser module;
each first electrode is positioned above the at least one support unit, the first laser module is configured to emit a laser beam to scan the cell when the conductive module of the first electrical input module is electrically connected to the upper surface and the lower surface of the cell, and the second laser module is configured to emit a laser beam to scan the cell when the conductive module of the second electrical input module is electrically connected to the upper surface and the lower surface of the cell; and
a position on the cell to be in contact with the first electrode of the second electrical input module at the second processing station is displaced away from a position on the same cell to be in contact with the first electrode of the first electrical input module at the first processing station.

2. The laser induced firing processing equipment according to claim 1, wherein the first electrode of the first electrical input module comprises at least one strip-shaped electrode element, which is referred to as a first front conductive unit, and the first electrode of the second electrical input module comprises at least one strip-shaped electrode element, which is referred to as a second front conductive unit.

3. The laser induced firing processing equipment according to claim 2, wherein the at least one strip-shaped electrode element of each first electrode comprises any one of an elastic probe row, an elastic conductive wire, or an elastic electrode sheet.

4. The laser induced firing processing equipment according to claim 2, wherein
the first processing station and the second processing station are arranged in sequence in a first direction, and the first front conductive unit and the second front conductive unit both extend in a direction perpendicular to the first direction; or
the first processing station and the second processing station are arranged perpendicularly to each other, the first front conductive unit extends in the first direction, and the second front conductive unit extends in a direction perpendicular to the first direction.

5. The laser induced firing processing equipment according to claim 4, wherein
the first electrode of the first electrical input module comprises a plurality of first front conductive units arranged side by side, and the first electrode of the second electrical input module comprises a plurality of second front conductive units arranged side by side, wherein
if the first processing station and the second processing station are arranged in sequence in the first direction, the plurality of first front conductive units and the plurality of second front conductive units are both arranged in sequence in the first direction; or
if the first processing station and the second processing station are arranged perpendicularly to each other, the plurality of first front conductive units are arranged in sequence in the direction perpendicular to the first direction, and the plurality of second front conductive units are arranged in sequence in the first direction.

6. The laser induced firing processing equipment according to claim 1, wherein
each second electrode is a conductive part that is arranged on or integrally formed on the at least one support unit, the conductive part is configured to be in contact with the lower surface of the cell, each conductive module further comprises a conductive connector, and the conductive connector is located above the at least one support unit and electrically connected to the power source; and
each of the first electrical input module and the second electrical input module further comprises a second driving mechanism that is connected to the first electrode and the conductive connector, and the second driving mechanism is configured to move the first electrode into contact with the upper surface of the cell, and move the conductive connector into contact with the conductive part to electrically connect the second electrode to the power source.

7. The laser induced firing processing equipment according to claim 6, wherein the conductive connector comprises at least one conductive pillar.

8. The laser induced firing processing equipment according to claim 6, wherein the conductive part is a conductive plate.

9. The laser induced firing processing equipment according to claim 8, wherein
the conductive plate has a greater size than that of the cell; and
when the at least one support unit is located at the first processing station and/or the second processing station, a projection of the first electrode on a horizontal plane faces a part of a busbar of the cell, and a projection of the conductive connector on the horizontal plane faces an area of the conductive plate in which the cell is not located.

10. The laser induced firing processing equipment according to claim 8, wherein
the second driving mechanism is a Z-axis driving module;
the first electrode and the conductive connector are connected to the Z-axis driving module; and
the Z-axis driving module is configured to lower the first electrode and the conductive connector simultaneously so that the first electrode comes into contact with the upper surface of the cell and the conductive connector comes into contact with the conductive plate.

11. The laser induced firing processing equipment according to claim 8, wherein the support module is a support table, the conductive plate is arranged on an upper surface of the support table, and the cell is placed on the conductive plate.

12. The laser induced firing processing equipment according to claim 11, wherein the support table is a negative-pressure-suction support table, a suction chamber is provided inside the support table, a plurality of first suction channels are provided in the surface of the support table and are in communication with the suction chamber, and the suction chamber is in communication with a vacuum generator.

13. The laser induced firing processing equipment according to claim 12, wherein the conductive plate is provided with a plurality of second suction channels, which are in communication with the plurality of first suction channels, and are configured for fixing the cell on the conductive plate by vacuum suction.

14. The laser induced firing processing equipment according to claim 12, wherein the plurality of first suction channels are not covered by the conductive plate.

15. The laser induced firing processing equipment according to claim 1, further comprising a positioning station, wherein
the positioning station is located upstream of the first processing station and the second processing station in a conveying direction of the cell in the laser induced firing processing equipment; and
a position adjustment mechanism is provided at the positioning station and is configured for adjusting a position of the cell, such that, when the cell, after being adjusted in position, is carried by the support unit to the first processing station and/or the second processing station, the first electrode directly faces a part of a busbar of the cell.

16. The laser induced firing processing equipment according to claim 1, wherein the support module comprises at least two support units for supporting the cell, and the first driving mechanism is configured to move one of the support units from the first processing station to the second processing station, and move another one of the support units to the first processing station at the same time.

17. The laser induced firing processing equipment according to claim 1, wherein
the support unit comprises a hollow portion, the second electrode is arranged under the hollow portion, each of the first electrical input module and the second electrical input module comprises a second driving mechanism connected to the first electrode and the second electrode, the second driving mechanism is configured to move the first electrode into contact with the upper surface of the cell, and move an electrode element of the second electrode through the hollow portion into direct contact with the lower surface of the cell.

18. The laser induced firing processing equipment according to claim 17, wherein each second electrode comprises any one of at least one strip-shaped electrode element, at least one conductive pillar, or a conductive plate.

19. The laser induced firing processing equipment according to any one of claims 1 to 18, wherein the support module is a rotary table module, the support unit is a support table, the first driving mechanism is a rotary driving mechanism, and the rotary table module comprises a centrosymmetric bracket that is horizontally arranged; and
a driving shaft of the rotary driving mechanism is vertically arranged and is connected to a center of the bracket, and the support module comprises at least two support units that are installed on the bracket and are equidistant from the center of the bracket.

20. The laser induced firing processing equipment according to claim 19, wherein
the rotary table module comprises four support units that are evenly distributed in a circumferential direction of the bracket, and the first processing station is arranged adjacent to the second processing station;
the first electrode of the first electrical input module comprises at least one strip-shaped electrode element, which is referred to as a first front conductive unit, and the first electrode of the second electrical input module comprises at least one strip-shaped electrode element, which is referred to as a second front conductive unit; and
the first front conductive unit extends in the first direction, and the second front conductive unit is arranged in a direction perpendicular to the first direction.

21. The laser induced firing processing equipment according to claim 20, further comprising a third station and a fourth station, wherein the first driving mechanism is configured to drive each support unit to pass through the third station, the first processing station, the second processing station, and the fourth station in sequence

22. The laser induced firing processing equipment according to claim 21, wherein
a loading conveyor is provided corresponding to the third station, and an unloading conveyor is provided corresponding to the fourth station; and
the third station is a loading station, the fourth station is an unloading station, and a connecting line between the loading station and the unloading station is parallel to a connecting line between the loading conveyor and the unloading conveyor.

23. The laser induced firing processing equipment according to claim 21, wherein
the third station is a loading station, and the fourth station is an unloading station;
a loading conveyor and a loading handling module are provided corresponding to the loading station, and an unloading conveyor and an unloading handling module are provided corresponding to the unloading station; and
a positioning station is provided between the loading conveyor and the rotary table module and is provided with a position adjustment mechanism.

24. The laser induced firing processing equipment according to claim 23, wherein
the loading conveyor is a belt conveyor, the loading handling module is an L-shaped rotary robotic arm assembly, the L-shaped rotary robotic arm assembly comprises a first rotary driving actuator and two robotic arms that are perpendicular to each other and are connected to the first rotary driving actuator, an end of each robotic arm is connected with a suction cup that faces downward and is configured to hold the cell by suction, and the L-shaped rotary robotic arm assembly is configured to rotate by 90 degrees each time;
the loading conveyor, the loading station, the unloading station, and the unloading conveyor are collinearly arranged in sequence, the position adjustment mechanism is located on a perpendicular bisector of a connecting line between the loading station and an output end of the loading conveyor, and the position adjustment mechanism is positioned directly below one of the suction cups when the L-shaped rotary robotic arm assembly stops moving after rotating by 90 degrees; and
the first rotary driving actuator is configured to move and locate the suction cups of the two robotic arms respectively above the position adjustment mechanism and the loading conveyor in one case, and above the position adjustment mechanism and the support unit corresponding to the loading station in another case.

25. The laser induced firing processing equipment according to claim 23, wherein
the position adjustment mechanism is a mechanical centering device, and the mechanical centering device comprises a support mechanism for supporting the cell, four push plates that are arranged around the support mechanism in a square form, and a driving unit connected to the push plates; and
the driving unit is configured to move the push plates towards a center of the cell to position the cell.

26. The laser induced firing processing equipment according to claim 23, wherein
the unloading conveyor is a belt conveyor, the unloading handling module is a straight rotary robotic arm assembly, and the straight rotary robotic arm assembly comprises a second rotary driving actuator and a straight robotic arm connected to the second rotary driving actuator, an end of the straight robotic arm is connected with a suction cup that faces downward and is configured to hold the cell by suction, and the straight rotary robotic arm assembly is configured to rotate by 90 degrees each time; and
the second rotary driving actuator is configured to move the suction cup of the straight robotic arm in a reciprocating manner between a position above the unloading conveyor and a position above the support unit corresponding to the unloading station.

27. The laser induced firing processing equipment according to claim 23, wherein
both the loading conveyor and the unloading conveyor are belt conveyors, both the loading handling module and the unloading handling module are linear robotic arm assemblies, the loading handling module comprises a loading driving actuator and two suction cups connected to the loading driving actuator, and the unloading handling module comprises an unloading driving actuator and a suction cup connected to the unloading driving actuator;
the loading conveyor, the positioning station, the loading station, the unloading station, and the unloading conveyor are collinearly arranged, the loading driving actuator is configured to move and locate the two suction cups of the loading handling module respectively above the loading conveyor and the position adjustment mechanism in one case, and above the position adjustment mechanism and the support unit corresponding to the loading station in another case; and
the unloading driving actuator is configured to move the suction cup of the unloading handling module in a reciprocating manner between a position above the unloading conveyor and a position above the support unit corresponding to the unloading station.

28. The laser induced firing processing equipment according to claim 23, wherein a loading buffer module is provided on a conveying path of the loading conveyor, and/or an unloading buffer module is provided on a conveying path of the unloading conveyor.

29. The laser induced firing processing equipment according to any one of claims 1 to 18, wherein
the support module is an alternating module, which further has a loading station and an unloading station, and the first processing station and the second processing station are located between the loading station and the unloading station;
the support module further comprises a base, on which the first processing station, the second processing station, the loading station and the unloading station are arranged; and
the first driving mechanism comprises two horizontal displacement modules respectively arranged on both sides of the base and at least two Z-axis modules connected to the horizontal displacement modules, the alternating module comprises at least two support units respectively connected to the at least two Z-axis modules, and the number of the Z-axis modules equals to the number of the support units.

30. The laser induced firing processing equipment according to any one of claims 1 to 18, wherein the support module is a conveying belt module, the conveying belt module comprises a belt, which serves as the support unit, and the first driving mechanism is configured to drive the belt to rotate.

31. The laser induced firing processing equipment according to any one of claims 1 to 18, wherein the support module is any one of a rotary table module, an alternating module, and a conveying belt module.
